**Europäisches Patentamt**

**European Patent Office**

**Office européen des brevets**

(19)

(11) Veröffentlichungsnummer: **0 009 605**
**B1**

(12) **EUROPÄISCHE PATENTSCHRIFT**

(45) Veröffentlichungstag der Patentschrift: **29.06.83**

(21) Anmeldenummer: **79103108.1**

(22) Anmeldetag: **23.08.79**

(51) Int. Cl.³: **H 01 L 23/36,**
**H 01 L 23/42, H 05 K 7/20**

(54) Kühlsystem für Halbleiter-Modul.

(30) Priorität: **02.10.78 US 947788**

(43) Veröffentlichungstag der Anmeldung:
**16.04.80 Patentblatt 80/8**

(45) Bekanntmachung des Hinweises auf die Patenterteilung:
**29.06.83 Patentblatt 83/26**

(84) Benannte Vertragsstaaten:
**DE FR GB**

(56) Entgegenhaltungen:
**DE - A - 2 006 467**
**DE - A - 2 231 282**
**DE - A - 2 441 613**
**DE - A - 2 748 948**

IBM TECHNICAL DISCLOSURE BULLETIN, Band
20, Nr. 11B, April 1978, New York E.
BERNDLMAIER et al. "Liquid-metal-cooled
integrated circuit modul structures"
IBM TECHNICAL DISCLOSURE BULLETIN, Band
20, Nr. 12, Mai 1978 New York M. CASES et al.
"LSI cooling technique"

(73) Patentinhaber: **International Business Machines**
**Corporation**
**Armonk, N.Y. 10504 (US)**

(72) Erfinder: **Balderes, Demetrios**
**30 Hiview Road**
**Wappingers Falls New York 12590 (US)**
Erfinder: **Lynch, John Richard**
**RD No. 6, Innsbruck Boulevard**
**Hopewell Junction New York 12533 (US)**
Erfinder: **Yacavonis, Robert Anthony**
**3 Feller Road**
**Poughkeepsie New York 12603 (US)**

(74) Vertreter: **Gaugel, Heinz, Dipl.-Ing.**
**Schönaicher Strasse 220**
**D-7030 Böblingen (DE)**

(56) References cited:
IBM TECHNICAL DISCLOSURE BULLETIN, Band
21, Nr. 1, Juni 1978, New York C. P.
COUGHLIN et al. "Thermally enhanced
semiconductor chip packaging structure"
IBM TECHNICAL DISCLOSURE BULLETIN, Band
21, Nr. 10, März 1979, New York W. J.
KLEINFELDER et al. "Liquid-filled bellows heat
sink"

Kühlsystem für Halbleiter-Modul

Die Erfindung bezieht sich auf ein Kühlsystem für Halbleiter-Modul mit einem von einem Gehäuse umgebenen Träger, auf dessen Oberfläche mindestens ein Halbleiterplättchen angeordnet ist, und mit einer die Oberfläche des Halbleiterplättchens mit einer Wärmesenke verbindenden Wärmeleitbrücke.

Mit der enormen Verdichtung der auf einem Halbleiterplättchen integrierbaren Schaltungen sind auch die Anforderungen an die Techniken gestiegen durch die die erzeugte Wärme abgeführt werden kann. Es ist also in der modernen hochintegrierten Halbleitertechnik erforderlich, Wärme von der Oberfläche der die Halbleiterelemente enthaltenden Halbleiterplättchen zu einer Wärmesenke in einem solchen Maße abzuleiten, daß die Betriebstemperatur des Halbleiterplättchens auf zulässiger Höhe gehalten werden kann. Die üblich Luftkühlung scheint ihre praktische Grenze erreicht zu haben, da die für eine ausreichende Kühlung erforderliche Luftmenge ein Geräuschproblem mit sich bringt und da ohne irgenwelche zusätzliche Hilfsmittel der zulässige Temperaturbereich nicht für alle Halbleiterplättchen im Rahmen einer Gesamtordnung mit vielen Halbleiterplättchen eingehalten werden kann. Im allgemeinen gilt, daß die Temperatur der Halbleiteranordnungen minimal etwa 293,15 K (20°C) und maximal etwa 358,15 K (85°C) betragen sollte. In manchen Fällen wird dieser Temperaturbereich auch beträchtlich verringert, um die geforderten Betriebsparameter halten zu könne. Das bedeutet aber auch, daß die Anforderungen an das Kühlsystem beträchtlich erhöht werden.

Eine andere Kühltechnik besteht darin, daß die Halbleiterkomponenten durch Eintauchen in eine Kühlflüssigkeit gekühlt werden. Als Flüssigkeiten werden dabei flüssige Fluorkohlenwasserstoffe verwendet, die einen niedrigen Siedepunkt haben. Diese Flüssigkeiten haben außerdem dielektrische Eigenschaften. Kühlsysteme dieser Art sind beispielsweise in den US-Patentschriften 3 774 677, 3 851 221 und 3 741 292 beschrieben. Da diese Kühlflüssigkeiten im Rahmen der Kühlung von Halbleitermoduls, die von einem Gehäuse umgeben sind, direkt mit der dort auf einem Träger angeordneten Halbleiterplättchen und mit der dort vorhandenen Leiterzügen auf dem Träger in Berührung kommen, sind extrem hohe Anforderungen an die Reinheit dieser Flüssigkeiten zu stellen. Verunreinigungen in der Kühlflüssigkeit sind meist der Ursprung für Korrosion der metallischen Leiterzüge, so daß die Lebensdauer der Anordnung verringert wird.

Eine weitere Art von Kühlung besteht darin, daß zwischen dem zu kühlenden Halbleiterplättchen und einer Wärmesenke eine wärmeleitende Verbindung hergestellt wird; für die wärmeleitende Verbindung ist ein niedriger Leitwiderstand zu fordern. Kühlsysteme dieser Art sind beispielsweise in den US-Patentschriften 4 034 469, 4 034 468 und 3 993 123 beschrieben. Dabei werden die die Wärmeleitung übernehmenden Wärmeleitbrücken aus festem Material hergestellt. Diese Wärmeleitbrücken stehen mit der Rückseite der auf den Träger aufgelöteten Halbleiterplättchen in Verbindung und sind zu der vorgesehenen Wärmesenke geführt. Diese Wärmeleitbrücken können starr oder auch federnd ausgeführt sein. Wesentlich bei diesen Systemen ist, daß zwischen der Wärmeleitbrücke und dem Halbleiterplättchen einerseits und der Wärmesenke andererseits jeweils innige, großflächige Kontakte bestehen, um den jeweils an der Grenzfläche auftretenden, hohen Wärmeleitwiderstand zu reduzieren. Zu diesem Zweck wurden wärmeleitende Pasten verwendet. Diese Lösung ist insbesondere bei Anordnungen, die bei relativ hohen Temperaturen betrieben werden, nicht zufriedenstellend. Diese Paste kann sich unter bestimmten Voraussetzungen von der Grenzfläche wegbewegen, so daß also wiederum ein hoher Übergangswiderstand entsteht, und sich an unerwüschten Stellen ansammelt und dort zu unerwünschten Verunreinigungen führt.

Der DE—A—2 231 282 ist bereits ein Kühlsystem für Halbleiterbauelemente zu entnehmen, bei dem zwischen dem zu kühlenden Halbleiterbauelement und einer Wärmesenke ein zumindest teilweise mit Hohlräumen versehener Körper als Wärmebrücke angeordnet ist. Die Hohlräume enthalten Metall, das im Normalbetribes-Temperaturbereich·des Bauelements fest ist. Im Normalbetriebsfall führt die Wärmebrücke die auftretende Wärme durch Wärmeleitung ab. Wird das Halbleiterbauelement kurzzeitig hoch belastet (Thermischer Impuls), so schmilzt das Metall in den Hohlräumen und nimmt über die auftretende Schmelzwärme die überschüssige Wärme auf.

Ein solches Kühlsystem, also insbesondere für Impulsbetrieb geeignet, hat den Nachteil, daß es im Normalbetriebs-Temperaturbereich mangelnde Wärmekontakte zwischen Oberfläche des Halbleiterchips und der Wärmebrücke einerseits und der Wärmebrücke und der Wärmesenke andererseits aufweist.

Es zeigt sich demnach, daß insbesondere für zukünftige Halbleiteranordnungen Kühlsysteme notwendig sind, die eine zuverlässige, unaufwendige und kontinuierlich wirksame Kühlung gewährleisten, wobei insbesondere ein möglichst geringer Wärmewiderstand an den auftretenden Grenzflächen gefordert werden muß.

Die Erfindung, wie sie in den Ansprüchen gekennzeichnet ist, löst die Aufgabe, bei einem Kühlsystem für ein Halbleiter-Modul die das Halbleiterplättchen mit einer darüber angeordneten Wärmesenke verbindende Wärmeleitbrücke so auszugestalten, daß sie einen niedrigen Wärmeleitwiderstand bildet, einen optimalen Wärmekontakt zwischen Halbleiterplättchen und Wärmesenke gewarleistet und keine Verunreinigung der Halbleiteranordnung hervorruft.

Im folgenden wird die Erfindung anhand von in der Zeichnung dargestellten Ausführungsbeispielen näher erläutert.

Es zeigen:

Fig. 1 die Schnittansicht eines Halbleiter-Moduls mit einem ersten Ausführungsbeispiel des erfindungsgemäßen Kühlsystems,

Fig. 2 die Schnittansicht eines Halbleiter-Moduls mit einem zweiten Ausführungsbeispiel des erfindungsgemäßen Kühlsystems,

Fig. 3 die Schnittansicht eines Halbleiter-Moduls mit einem dritten Ausführungsbeispiel des erfindungsgemäßen Kühlsystems und

Fign. 4A und 4B eine schematische Darstellung, in vergrößertem Maßstab, des Prinzips der beim erfindungsgemäßen Kühlsystem ausgenutzten Kapillarwirkung.

Durch die Erfindung wird der thermische Widerstand an der Grenzfläche zwischen dem Halbleiterplättchen oder einem anderen wärmeerzeugenden Bauelement und der kühlenden Wärmesenke, also beispielsweise einer Kühlplatte oder einer Anordnung von Kühlrippen dadurch vermindert, daß ein wärmeleitendes flüssiges Medium vorgesehen wird, das mit Hilfe eines Blockes aus porösem Material in seiner vorgesehenen Lage gehalten wird. Das poröse Material dient gleichzeitig als Flüssigkeitsreservoir, über das die Flüssigkeit nachgeliefert wird, die an den Grenzflächen erforderlich ist. Die Flüssigkeit sorgt für völlig angepaßte Grenzflächen zwischen dem Halbleiterplättchen und der das eigentliche Kühlelement bildenden Wärmesenke, so daß ein optimaler Wärmeübergang stattfindet.

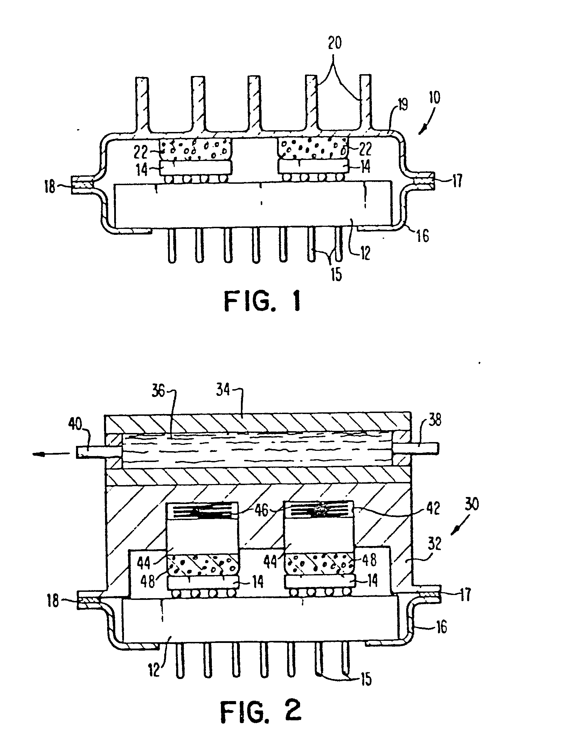

Zunächst sei das in Fig. 1 dargestellte erste Halbleiter-Modul 10 näher betrachtet. Es umfaßt einen Träger 12 aus isolierendem oder dielektrischem Material. Über diesen Träger 12 werden die elektrischen Leiterzüge zwischen den Anschlüssen der Halbleiterplättchen 14, die auf dem Träger angeordnet sind, und den Anschlußstiften 15 hergestellt. Außerdem sind auf dem Träger 12 Leiterzüge als Zwischenverbindungen zwischen den einzelnen Halbleiterplättchen angeordnet. Üblicherweise besteht der Träger 12 aus keremischem oder organischem Material und trägt auf seiner Oberfläche oder auch in seinem Innern die Metallisierungsebenen, über die die genannten elektrischen Verbindungen hergestellt werden. Ist eine große Anzahl von Halbleiterplättchen 14 auf dem Träger 12 anzuordnen und weiterzuverbinden, so besteht der Träger vorzugsweise aus einer Mehrlagen-Keramikschicht, die also mehrere Metallisierungslagen und leitende Querverbindungen aufweist. Die Halbleiterplättchen 14 sind vorzugsweise auf die Oberflächen des Trägers 12 aufgelötet, wie es beispielsweise in den US-Patentschriften 3 429 040 und 3 495 133 beschrieben ist. Die Anschlußstifte sind mit dem Träger in bekannter Weise verbunden. An die Unterseite des Trägers 12 ist ein Flansch 16 angebracht, der eine Auflagefläche 17 bildet. Auf dieser Auflagefläche 17 leigt die Fläche 18 eines die Gesamtanordnung abdeckenden Gehäuses 19 auf. Dieses Gehäuse 19 ist mit Kühlrippen 20 versehen. Bei der hier betrachteten Ausführung wird die von den Halbleiterplättchen 14 erzeugte Wärme über Wärmeleitbrücken 22 an die Unterseite des Gehäuses 19 geleitet. Die Wärmeleitbrücken 22 bestehen aus porösem Material, das mit wärmeleitender Flüssigkeit vollgesaugt ist. Aufgrund der auftretenden Kapillarwirkung bildet die Flüssigkeit die Grenzflächen mit den Halbleiterplättchen 14 und mit der Unterseite des Gehäuses 19.

Das in Fig. 2 gezeigte Halbleiter-Modul 30 verwendet ebenfalls das erfingungsgemäße Kühlsystem. Das Modul umfaßt einen Träger 12 mit Anschlußstiften 15. Wie beim Ausführungsbeispiel nach Fig. 1 sind Halbeiterplättchen 14 auf der Oberfläche des Trägers 12 angeordnet. Wiederum ist am Träger 12 zur Bildung einer Auflagefläche für eine Gehäuseabdeckung 32 ein Flansch 16 angebracht. Auf dem Gehäuse 32 ist eine Kühlenrichtung 34 aufgebracht, die eine mit einer geeigneten Kühlflüssigkeit gefüllte Kammer 36 aufweist. Die Kühlflüssigkeit wird über einen Einlaß 38 zugeführt und über einen Auslaß 40 abgeleitet. In der Gehäuseabdeckung 32 sind Zylinder 42 über den Halbleiterplättchen 14 vorhanden. In diesen Zylindern 42 befinden sich beweglich gelagerte Kolben 44, die durch Federn 46 gegen die Halbleiterplättchen 14 gedrückt werden. Dabei sit zwischen der Oberfläche der Halbleiterplättchen 14 und den Kolben die erfindungsgemäße Wärmeleitbrücke 48 aus porösem Material eingebracht. Diese Wärmeleitbrücke kann lose angeordnet oder auch mit dem Kolben 44 verbunden sein. In einer Weiterbildung kann auch der gesamte Kolben aus porösem mit Flüssigkeit gefülltem Material bestehen. Die Wärmeleitbrücke 48 bildet also, wie im Ausführungsbeispiel nach Fig. 1 die Grenzfläche zum Halbleiterplättchen 14. Das Gehäuse 32 ist mit dem Flansch 16 dicht und fest verbunden.

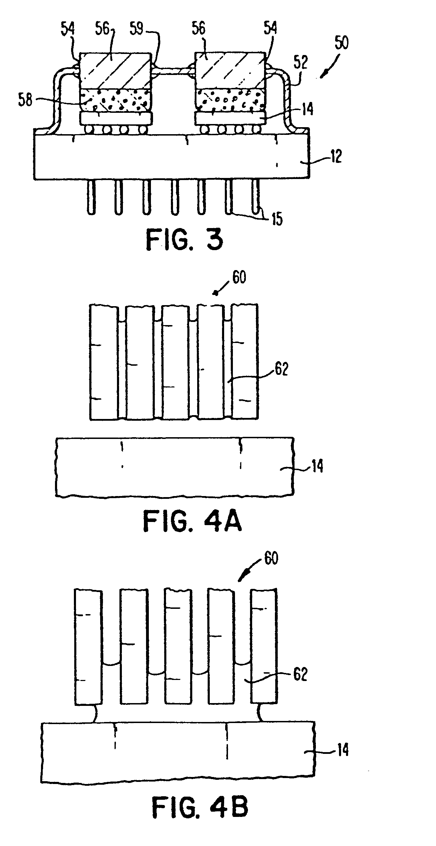

Das in Fig. 3 gezeigte Halbleiter-Modul enthält wiederum einen geeigneten Träger 12, der die Anschlußstifte 15 für die auf dem angeordneten Halbleiterplättchen 14 beträgt. Auf irgendeine geeignete Art ist das Gehäuse 52 mit dem Substrat 12 verbunden. Das Gehäuse 52 weist über jedem Halbleiterplättchen 14 eine Öffnung 54 auf. In jeder Öffnung 54 ist ein vorzugsweise aus einem Metall bestehender Zapfen 56 angeordnet, dessen Endteil 58 wiederum aus porösem Material besteht. Erfindungsgemäß ist das poröse Material mit der wärmeleitenden Flüssigkeit gefüllt. Beim Zusammenbau des Halbleiter-Moduls 50 geht man so vor, daß zunächtst das Gehäuse 52 auf das Substrat 12 aufgebracht und befestigt wird und daß dann die Zapfen 56 in die Öffnungen 54 bis zur Berührung mit der Oberfläche der Halbleiterplättchen 14 eingebracht werden. Anschließend werden die Zapfen 56 mit dem Gehäuse 52 beispielsweise verlötet, so daß eine hermetische Abdichtung entsteht.

Bei der Auswahl des porösen Materials für die Wärmeleitbrücken und der wärmeleitenden Flüssigkeit für das erfindungsgemäße Kühlsystem sind eine Reihe von Überlegungen anzustellen. Drei Erfordernisse müssen erfüllt sein, um die angestrebten Ziele zu erreichen. Die Systemenergie muß begünstigen, daß die Flüssigkeit den Spalt zwischen dem Halbleiterplättchen und der Wärmesenke füllt. Die auftretenden Kapillarkräfte sollten nicht so hoch sein, daß die Flüssigkeit in zwei getrennte Tropfen, nämlich auf dem Halbleiterplättchen und auf der Wärmesenke getrennt wird. Schließlich soll die Systemenergie unterstützend wirken, daß die Flüssigkeit den Spalt zwischen Halbleiterplättchen und Wärmesenke und außerdem das Flüssigkeitsreservoir im porösen Material füllt.

Weiterhin sind folgende Bedingungen zu stellen. Selbstverständlich dürfen zwischen den einzelnen Elementen keine chemischen Reaktionen stattfinden, die Auswirkungen auf die angestrebte Funktion habem könnten.

Einerseits wird man das poröse Material, die Oberfläche der Anordnung und die Flüssigkeit so auswählen, daß die Benetzbarkeit des porösen Materials ausreicht, um die Flüssigkeit in das poröse Material aufzusaugen, andererseits ist aber auch darauf zu achten, daß die auftretende Kapillarwirkung nicht so groß ist, daß die Flüssigkeit von der Oberfläche der Halbleiterplättchen abgezogen wird. Allgemein kann gesagt werden, sowohl das poröse Material als auch die Oberfläche der Halbleiterplättchen muß mit der wervendeten Flüssigkeit benetzbar sein. Wäre das poröse Material nicht benetzbar, so würde die Flüssigkeit nicht absorbiert werden. Wäre die Oberfläche der Halbleiterplättchen beträchtlich höher benetzbar als das poröse Material, so würde die Flüssigkeit von der Oberfläche der Halbleiterplättchen abgezogen. Es ist darauf hinzuweisen, daß die Rückseite der Halbleiterplättchen, die mit dem porösen Material in Berührung stehen, mit einem geeigneten Überzug versehen werden kann, der die gewünschte Benetzbarkeit sicherstellt. Mit einem Kreisring aus nicht benetzbarem Material, der auf die Oberfläche des Halbleiterplättchens aufgebracht wird, kann eine Entfernung der Flüssigkeit ais dem porösen Material für den Fall verhindert werden, daß die Benetzbarkeit der Oberfläche des Halbleiterplättchens beträchtlich höher ist als die des porösen Materials.

Im Zusammenhang mit den Überlegungen zur Benetzbarkeit steht die Größe der im porösen Material vorhandenen Kapillaren. Unter gleichen Bedingungen kann man feststellen, daß die Kapillarkräfte, die die Flüssigkeit in das poröse Material ziehen, umso größer sind, je kleiner der Durchmesser der Kapillaren ist. Die Beziehung, die die Variablen des Systems definiert und sicherstellt, daß die Systemenergie abnimmt, wenn der Spalt zwischen Halbleiterplättchen und Wärmesenke mit Flüssigkeit gefüllt ist, lautet:

$$d > \frac{X}{A - VX/D} \qquad (1)$$

Dabei ist d der Durchmesser der Kapillaren, X der Abstand, also der Spalt zwischen Halbleiterplättchen und Kühlelement bzw. Wärmesenke, A eine Konstante, V die relative Oberflächenspannungskontante und D der Durchmesser der Wärmesenke. Es seien nun die Fign. 4A und 4B näher betrachtet. Dargestellt ist schematisch ein Halbleiterplättchen 14 in enger Nachbarschaft zu einem porösen, also Kapillaren aufweisenden Körper 60. Die Porösität ergibt sich aus einer Vielzahl von axial parallel angeordneten Kapillaren. Ist die in der vorstehenden Beziehung angegebene Bedingung erfüllt, so ergibt sich die in Fig. 4B dargestellte Situation. Die Flüssigkeit 62 kontaktiert die Oberfläche des Halbleiterplättchens 14. Der in Fig. 4A dargestellte Zustand könnte entstehen, wenn die Oberflächenspannung auf dem Halbleiterplättchen 14 nicht ausreichend hoch ist, um die Flüssigkeit 62 anzuziehen und/oder wenn der Durchmesser der Kapillaren unter Berücksichtigung der Oberflächenspannung so klein ist, daß die Flüssigkeit in sie hineingezogen werden kann, oder schließlich wenn der Spalt, also der Abstand zwischen Wärmebrücke und Halbleiterplättchen zu groß ist.

Eine Bedingung ist auch, daß die Kapillarkräfte nicht so hoch sind, daß die Oberflächenspannung der Flüssigkeit im Spalt zwischen Halbleiterplättchen und Wärmebrücke überwunden wird. Die folgenden Beziehungen verhindern das Eintreten dieses Zustandes.

$$d < D \frac{B}{n} \qquad (2)$$

$$F \leq \gamma_{FA} D \qquad (3)$$

Dabei ist B eine relative Oberflächenenergiekonstante, n die Anzahl der Kapillaren im porösen Material, F die Kraft auf das Halbleiterplättchen, $\gamma_{FA}$ die Flüssigkeit-Atmosphären-Oberflächenenergie und D der Durchmesser der Wärmesenke.

Eine weitere Forderung kann darin bestehen, daß die Flüssigkeit auch bei über der Schwerkraft liegenden Beschleunigungen im porösen Material und im Spalt zwischen Halbleiterplättchen und Wärmebrücke verbleibt. Es sei hier angenommen, es umfasse die Gesamtenergie einer Kapillare, um einen Flüssigkeitstropfen kritischer Größe vom porösen Material zu trennen. Führt man die Größe der Systemenergie ein, so liefert die folgende Beziehung eine Aussage über die maximal zulässige Beschleunigung des Systems in Abhängigkeit von der Länge und dem Durchmesser der Kapillaren des porösen Materials, dem Verhältnis der Oberflächenenergie zur Dichte der Flüssigkeit und der relativen Benetzbarkeit.

$$a < 2\frac{\nu}{p} \; \frac{A\,(d^2 1)^{2/3} + Bdl - Cd^2}{d^2 1^2} \quad (4)$$

Dabei ist a die maximale Beschleunigung,

$$\frac{\nu}{p}$$

das Verhältnis der Oberflächenenergie zur Dichte der Flüssigkeit, d der Durchmesser der Kapillaren des porösen Materials, und es sind A, B, und C die relativen Oberflächenenergiekonstanten.

Als Flüssigkeiten sind verwendbar beispielsweise Metalle, deren Schmelzpunkt bei oder unterhalb der Raumtemperatur liegt, was biespielsweise für Quecksilber, Gallium und Galliumverbindungen und Indiumverbindungen zutrifft. Auch verschiedene organische Flüssigkeiten sind verwendbar, beispielsweise Transformatorenöle. Ebenso sind Silikonöle einsetzbar. Man kann festhalten, daß solche Flüssigkeiten praktisch verwendbar sind, die einen niedrigen Dampfdruck aufweisen und die in den voranstehenden beziehungen erwähnten Kriterien erfüllen.

Das Material für die Wärmeleitbrücke muß die ebenfalls in den voranstehenden Beziehungen aufgestellten Kriterien erfüllen. Typische Materialien sind gepresste Drahtgeflechte, zusammengepresste, axial parallel angeordnete Metalldrähte und gesinterte keramische oder metallische Teilchen. Das Material muß inert gegen die Flüssigkeit sein oder aber mit einem geeigneten Material beschichtet werden. Wolfram und Molybdän sind besonders geeignet und brauchen nicht beschichtet werden. Dagegen sind Kupfer, Gold, Silber und ähnliche Metalle ungeeignet, da sie sich beispielsweise mit Gallium verbinden. Diese Materialien sind also nur einsetzbar, wenn sie beispielsweise mit einem inerten Material beschichtet werden. Wesentlich ist, daß das für die Wärmebrücke verwendete poröse Material ebenfalls gut wärmeleitend ist.

Der Spalt zwischen Halbleiterplättchen und Wärmebrucke muß mit Vermeidung der geschilderten Probleme relativ klein gehalten werden. Verwendet man als Flüssigkeit Metalle, so kann dieser Spalt in der Größenordnung von 0,4 mm liegen. Bei Verwendung von organischen Flüssigkeiten und Silikonölen sollte dieser Spalt geringer als beispielsweise 0,4 mm groß sein. Da Silikonöl ein kleines Verhältnis

$$\frac{\nu}{p}$$

aufweist, ist es nicht für Systeme verwendbar, bei denen der genannte Spalt größer als etwa 0,13 mm ist. Da kolbenartige Wärmeleitbrücken bei üblicher Fertigung nicht mit der erforderlichen Toleranz herstellbar sind, verwendet man beim Ausführungsbeispiel gemäß Fig. 2 federnde Kolben, um den positiven Kontakt zwischen Kolben und Oberfläche des Halbleiterplättchens sicherzustellen. Da bei positiven Kontakt die Flüssigkeitsspannung unwesentlich ist, kann das Kriterium der Oberflächenenergiedichte in der Beziehung (2) vernachlässigt werden. Das bedeutet, daß auch ein Kolben aus gesintertem Metall verwendbar ist. Ein poröses Endstück des Kolbens liefert in jedem Falle soviel Flüssigkeit, also beispielsweise Silikonöl nach, daß auch bei schlechter Ausrichtung des Kolhens auf das Halbleiterplättchen eventuell entstehende Spalte überbrückt werden.

## Patentansprüche

1. Kühlsystem für Halbleiter-Modul mit einem von einem Gehäuse (19, 32, 52) umgebenen Träger (12), auf dessen Oberfläche mindestens ein Halbleiterplättchen (14) angeordnet ist, und mit einer die Oberfläche des Halbleiterplättchens (14) mit einer Wärmesenke verbindenden Wärmeleitbrücke (22, 48, 58), dadurch gekennzeichnet, daß die Wärmeleitbrücke (22, 48, 58) aus porösem Material besteht, das eine wärmeleitende, nicht flüchtige Flüssigkeit absorbiert hat und stationär festhält, und daß die Flüssigkeit völlig angepaßte Grenzflächen zwischen dem Halbleiterplättchen (14) und der Wärmesenke bildet und den Spalt zwischen dem Halbleiterplättchen und der Wärmesenke ausfüllt.

2. Kühlsystem nach Anspruch 1, dadurch gekennzeichnet, daß die Wärmeleitbrücke aus Metallwolle besteht.

3. Kühlsystem nach Anspruch 1, dadurch gekennzeichnet, daß die Wärmeleitbrücke aus in keramisches Material eingebettetem Faserstoff besteht.

4. Kühlsystem nach einem der Ansprüche 1 bis 3, dadurch gekenzeichnet, daß die Flissipkeit aus Metall besteht.

5. Kühlsystem nach enem der Ansprüche 1 bis 3, dadurch gekennzeichnet, daß die Flüssigkeit aus der Gruppe enthaltend Transformatorenöl und Silikonöl ausgewählt ist.

## Revendications

1. Système de refroidissement pour modules à semi-conducteurs comportant un support (12) entouré par un boîtier (19, 32, 52) sur la surface duquel est monté au moins une microplaquette semi-conductrice (14), et comportant un élément de transfert de charleur (22, 48, 58) reliant la surface de la microplaquette semi-conductrice (14) à un puits de chaleur, caractérisée en ce que: l'élément de transfert de chaleur (22, 48, 58) est réalisé en matériau poreux, qui est imprégné d'un liquide stationnaire, non volatile et conducteur de chaleur, le liquide formant un contour qui épouse parfaitement l'interface existant entre la microplaquette semiconductrice (14) et le puits de chaleur et remplissant l'espace compris entre la microplaquette de semi-conductrice et le puits de chaleur.

2. Système de refroidissement selon la revendication 1 caractérisé par le fait que l'élément de transfert chaleur se compose de laine de métal.

3. Système de refroidissement selon la revendication 1, caractérisé par le fait que l'élément de transfert de chaleur se compose de fibres noyées dans un matériau céramique.

4. Système de refroidissement selon l'une quelconque des revendications 1 à 3, caractérisé par le fait que le liquide est remplacé par du métal.

5. Système de refroidissement selon l'une quelconque des revendications 1 à 3, caractérisé par le fait que le liquide a été choisi dans le groupe contenant l'huile des transformateurs et l'huile au silicone.

## Claims

1. Cooling system for semiconductor modules with a substrate (12) surrounded by a casing (19, 32, 52) having arranged on its surface at least one semiconductor wafer, and with a heat transfer member (22, 48, 58) connecting the surface of the semiconductor wafer (14) to a heat sink, characterized in that the heat transfer member (22, 48, 58) consists of porous material which is impregnated with a heat conductive, non-volatile liquid that is retained stationary, and that the liquid forms fully adapted interfaces between the semiconductor wafer (14) and the heat sink, and fills the gap between the semiconductor wafer and the heat sink.

2. Cooling system as claimed in claim 1, characterized in that the heat transfer member consists of metal wool.

3. Cooling system as claimed in claim 1, characterized in that the heat conducting member consists of fibers embedded in ceramic material.

4. Cooling system as claimed in any one of claims 1 to 3, characterized in that the liquid consists of metal.

5. Cooling system as claimed in any one of claims 1 to 3, characterized in that the liquid is selected from the group containing transformer oil and silicon oil.

FIG. 1

FIG. 2

FIG. 3

FIG. 4A

FIG. 4B